# EUROPEAN PATENT APPLICATION

(11) **EP 2 239 795 A1**
(43) Date of publication of application: **13.10.2010**
(21) Application number: 09157797.3
(22) Date of filing: 10.04.2009
(51) Int. Cl.: H01L 45/00, H01L 27/24

(54) **Method for manufacturing a memory element comprising a resistivity-switching NiO layer and devices obtained thereof**

(71) Applicant: IMEC, 3001 Leuven (BE)
(72) Inventor: Lisoni Reyes, Judit, 3050 Oud-Heverlee (BE); Goux, Ludovic, 4280 Hannut (BE); Wouters, Dirk, 3001 Leuven (BE)
(74) Representative: Hertoghe, Kris Angèle Louisa

(57) **Abstract**

The present invention provides a method for forming a NiO resistive memory element comprising a NiO resistive switching layer (31). The method comprises obtaining a substrate (34), providing a Ni layer on the substrate, and at least partially oxidizing the Ni layer, thus forming the NiO resistive switching layer (31), wherein obtaining a substrate comprises obtaining a substrate which promotes subsequent formation of Ni grains with slower oxidizing crystal orientations, e.g. (111) orientations, and/or suppresses formation of Ni grains with faster oxidizing crystal orientations, e.g. (100) orientations. This may be obtained, for example, by providing on the substrate, a N-rich, Ti-poor TiN bottom electrode layer. By providing a substrate which promotes subsequent formation of Ni grains with slower oxidizing crystal orientations and/or suppresses formation of Ni grains with faster oxidizing crystal orientations, resistive memory elements with good switching properties may be formed.

## Description

### Field of the invention

The present invention is related to non-volatile memory devices comprising a reversible resistivity-switching layer used for storing data. The resistivity of this layer can be varied between at least two stable resistivity states such that at least one bit can be stored therein. In particular this resistivity-switching layer is a NiO.

The present invention relates to methods for forming such non-volatile memory devices with good switching properties, and to non-volatile memory devices thus obtained.

### Background of the invention

Among the most promising non-volatile memory technologies are resistive-switching memories, also known as Resistive Random Access Memories (ReRAMs). Such a ReRAM memory cell comprises a memory element and a selection element. The resistivity of the non-volatile memory element can be reversibly varied between at least two stable resistivity states employing a voltage- or current-induced resistivity change of a material. Examples of such reversible resistivity-switching active material are chalcogenides, carbon polymers, selected binary metal oxides such as nickel-oxide, tungsten-oxide, cupper-oxide, ternary metal oxides such as nickel-cobalt-oxide or even more complex metal oxides such as Cr-doped Sr(Ti)ZrO₃ or Pr_{0.7}Ca_{0.3}Mn_{0.3}.

Material properties are an important factor of electrical behavior, in particular switching behavior, of the ReRAM memory cells.

Simple binary transition metal oxides have recently attracted lots of attention for their resistive switching behavior. In particular NiO is a promising candidate for non-volatile memory devices due to its compatibility with standard CMOS process. In most cases, polycrystalline oxide films are deposited by reactive sputtering on conductive substrates to form bi-stable metal/resistive oxide/metal (MRM) structures. In L. Courtade et al., "Resistive switching and microstructure of NiO binary oxide films developed for OxRRAM non-volatile memories", ICMTD 2007, an alternative way is explored to obtain NiO films from the controlled oxidation of a Ni metallic film: oxidation in a Rapid Thermal Annealing (RTA) furnace of a blanket Ni metallic film used as bottom electrode. The Ni film is progressively consumed as the NiO film grows, up to the total consumption of the Ni layer.

Furthermore, it is known from Kaname Matsumoto et al., "Long-Length Y-Ba-Cu-O Coated Conductors Produced by Surface-Oxidation Epitaxy Method", IEEE Transactions on Applied Superconductivity, Vol. 11, No. 1, March 2001, that preferred orientations of NiO grown on the Ni(100) surface are NiO(111) and NiO(100), and that NiO(100) becomes dominant at elevated temperatures above 1000°C in air.

When manufacturing ReRAM memory cells, it is observed that a lot of such ReRAM memory cells have bad switching properties, such as e.g. metal oxide films being too leaky, metal oxide films being too resistive, no reproducible switching events being available, or irreversible switching events whereby e.g. the memory cell remains in OFF state after first switching.

### Summary of the invention

It is an object of embodiments of the present invention to provide ReRAM memory cells with good switching properties. Good switching properties may include large enough voltage window between switching to low resistance state (LRS) and to high resistance state (HRS) and reproducible switching events.

The above objective is accomplished by methods and devices according to embodiments of the present invention.

In particular, in accordance with embodiments of the present invention, the control of the quality of the switching properties of an ReRAM device is obtained via the control of the initial/as grown Ni crystal orientation.

In a first aspect, the present invention provides a method for forming a NiO resistive memory element, the memory element comprising a NiO resistive switching layer. The method comprises obtaining a substrate, providing a Ni layer on the substrate, and at least partially oxidizing the Ni layer, thus forming the NiO resistive switching layer, wherein obtaining a substrate comprises obtaining a substrate which promotes subsequent formation of Ni grains with slower oxidizing crystal orientations, e.g. (111) orientations, and/or suppresses formation of Ni grains with faster oxidizing crystal orientations, e.g. (100) orientations. By providing a substrate which promotes subsequent formation of Ni grains with slower oxidizing crystal orientations and/or suppresses formation of Ni grains with faster oxidizing crystal orientations, resistive memory elements with good switching properties may be formed.

Obtaining a substrate may include selecting a substrate which has a crystal structure such that, when subsequently forming a Ni layer on top, formation of Ni grains with slower oxidizing crystal orientations, e.g. (111) orientations, is promoted, and/or formation of Ni grains with faster oxidizing crystal orientations, e.g. (100) orientations, is suppressed. Obtaining a substrate may include providing such substrate.

In alternative embodiments, obtaining a substrate may include obtaining a substrate provided with bottom electrode layers which are selected such that, when subsequently forming a Ni layer on top, formation of Ni grains with slower oxidizing crystal orientations, e.g. (111) orientations, is promoted, and/or formation of Ni grains with faster oxidizing crystal orientations, e.g. (100) orientations, is suppressed. Obtaining such substrate may include providing a substrate with such bottom electrode layers which are selected such that, when subsequently forming a Ni layer on top, formation of Ni grains with slower oxidizing crystal orientations, e.g. (111) orientations, is promoted, and/or formation of Ni grains with faster oxidizing crystal orientations, e.g. (100) orientations, is suppressed.

In a method according to embodiments of the present invention, obtaining a substrate may comprise obtaining a substrate provided with a N-rich, Ti-poor TiN layer. This means that the TiN layer has an excess of N in the TiN layer; Ti/N < 1. Obtaining the substrate may comprise obtaining the substrate and providing such N-rich, Ti-poor TiN bottom electrode layer on the substrate. This TiN layer may form part of the bottom electrode of the resistive memory device.

In accordance with alternative embodiments of the present invention, providing a Ni layer may comprise growing epitaxial (111) Ni. This is a solution providing good switching results. However, it is not always possible to implement this as epitaxial growth is expensive, decreases throughput because it is a slow process, and the process window of subsequent layers do not necessarily match.

After forming the Ni layer but before oxidizing it, an anneal step (further called pre-anneal) may be carried out on the Ni layer. This pre-anneal enhances the crystal orientation of the Ni layer so that more Ni(111) and less Ni(100) is present.

During the at least partial oxidation of the Ni layer, the parameters of the oxidation process may be selected so as to provide a substantially uniform oxidation over the substrate, more particularly over the Ni layer. This enhances the quality and hence the switching properties of the formed NiO layer.

In a method according to embodiments of the present invention, providing a substrate may comprise providing a substrate with a stable bottom electrode material. This stable bottom electrode material may be present at one or more locations on the substrate where a memory element is to be formed, hence where a Ni layer is to be provided. With a stable bottom electrode material is meant a bottom electrode material which, after the processing of the resistive memory element, does not degrade the switching properties of the resistive memory element. It keeps its structure during subsequent processing, and it is non-volatile so that it does not release components during subsequent processing.

A method according to embodiments of the present invention may furthermore comprise forming a top electrode on the NiO resistive switching layer.

In a further aspect, the present invention provides a resistivity-switching non-volatile memory element obtained by a method according to embodiments of the present invention.

In yet another aspect, the present invention provides a resistivity-switching non-volatile memory element comprising a bottom electrode and a NiO resistive switching layer, wherein the bottom electrode comprises a N-rich, Ti-poor TiN layer. This means that the TiN layer has an excess of N in the TiN layer; Ti/N < 1.

The present invention also provides a memory cell comprising a resistivity-switching non-volatile memory element according to embodiments of the present invention, and a selection element for selecting the memory element when coupled in an array of memory elements or in a further circuit. Furthermore, such memory cell may comprise an interconnect structure allowing electrical access to the memory element for programming, writing and erasing thereof.

In a further aspect, the present invention provides a method for promoting formation of Ni grains with (111) orientation, the method comprising providing a N-rich, Ti-poor TiN bottom electrode layer under the Ni layer.

Particular and preferred aspects of the invention are set out in the accompanying independent and dependent claims. Features from the dependent claims may be combined with features of the independent claims and with features of other dependent claims as appropriate and not merely as explicitly set out in the claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

### Brief description of the drawings

FIG. 1 illustrates the process of unipolar switching in NiO ReRAM.
FIG. 2 illustrates the process of bipolar switching in NiO ReRAM.
FIG. 3 is a diagrammatic illustration of a ReRAM memory element.
FIG. 4a to FIG. 4d illustrate process steps in the manufacturing of an ReRAM memory element as illustrated in FIG. 3.
FIG. 5 shows X-ray diffractograms of the Ni(200) component of Ni deposited on TiN or on a multilayer stack comprising Ti and TiN deposited by different methods.
FIG. 6 shows that ReRAMs made from the above stacks of which X-ray diffractograms are illustrated in FIG. 5 do not all show good switching.
FIG. 7 shows X-ray diffractograms of Ni films after a pre-anneal.
FIG.8 shows a graph illustrating the relationship between Ni(200) and Ni(111) presence after pre-anneal as in FIG. 7.
FIG. 9 shows X-ray diffractograms of partially oxidized Ni films for different bottom electrode compositions.
FIG. 10a is a SEM picture of a TiN Endura layer onto which a Ni layer is applied, which is then oxidized. FIG. 10b is a SEM picture of a TiN Anelva layer onto which a Ni layer is applied, which is then oxidized.

The drawings are only schematic and are non-limiting. In the drawings, the size of some of the elements may be exaggerated and not drawn on scale for illustrative purposes.

In the different drawings, the same reference signs refer to the same or analogous elements. Any reference signs in the claims shall not be construed as limiting the scope.

### Detailed description of illustrative embodiments

The physical mechanism behind ReRAMs, allowing conversion from one resistivity state (e.g. LOW or HIGH) to another resistivity state (e.g. HIGH or LOW) upon applying a current or voltage signal to the active switching material, depends on the switching material used in a ReRAM memory cell. In particular, the resistivity switching in a binary nickel-oxide non-volatile memory was shown to be based on the respective formation/rupture of narrow filamentary conductive paths throughout the nickel-oxide films as disclosed inter alia by D.C. Kim, S. Seo, S.E. Ahn et al. in Applied Physics Letter 88(20), 202102 (2006).

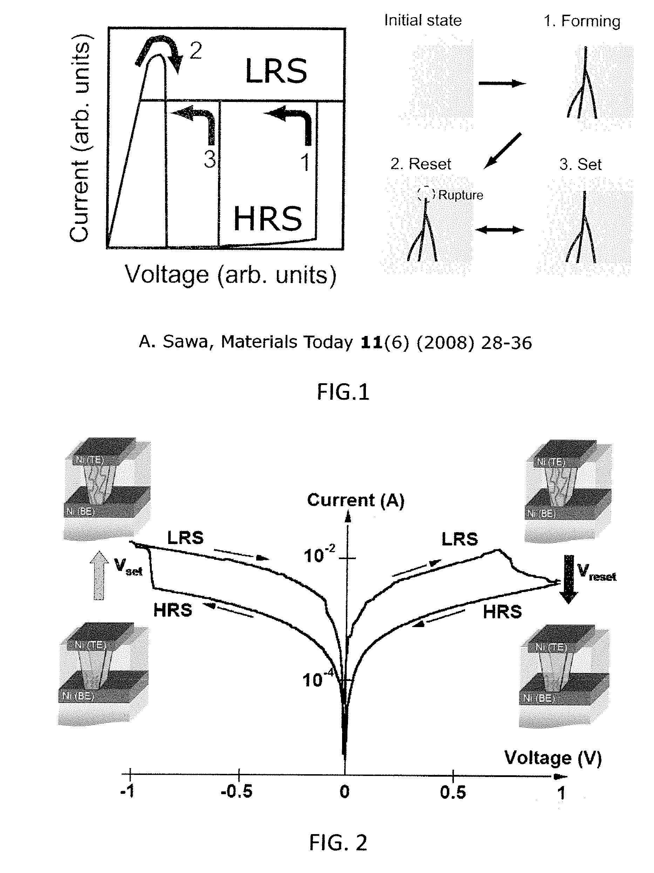

Initially, i.e. after forming the nickel-oxide layer and before applying any external electrical bias, the nickel-oxide layer is in a high-resistivity state. A voltage, indicated 1 in the left hand part of FIG. 1, in the range of several volts, e.g. 4 to 6V, is to be applied to form a reversible resistivity-switching nickel-oxide layer. This transition from an initial high-resistivity state to a lower-resistivity state is most probably due to the initiation of conductive filament paths in the nickel-oxide layer between a top electrode and a bottom electrode. This process is called the electro-forming process and requires an initial voltage signal, indicated 1 in the left hand part of FIG. 1, with amplitude higher than the amplitude, indicated 3 in the left hand part of FIG. 1, required to, thereafter, switch the ReRAM memory element between the stable resistivity states.

After electro-forming the nickel-oxide layer by an initial voltage signal, indicated 1 in the left hand part of FIG. 1, the ReRAM memory element can be reversibly 'set' and 'reset'. The 'set' switching, i.e. the switching to the ON state or low resistivity state LRS, is voltage controlled, as indicated by 3 in the left hand part of FIG. 1. The physical mechanism allowing setting of a nickel-oxide ReRAM memory element is probably similar to a soft breakdown mechanism as it creates conductive filament paths between the bottom electrode and the top electrode. The 'reset' switching, indicated 2 in the left hand part of FIG. 1, i.e. the swithing to the OFF state or high resistivity state HRS, is current controlled and is believed to be due to an electro-thermal mechanism disrupting the conductive filament paths between the bottom electrode and the top electrode.

As shown in FIG. 1 compared to FIG. 2, the nickel-oxide ReRAM memory element can be operated in both unipolar and bipolar mode for 'reset' and 'set' switching thereof. In an unipolar operation (FIG. 1) the 'set' and 'reset' voltage signals are of the same polarity, i.e. either negative or positive, while in a bipolar operation (FIG. 2) the 'set' and 'reset' voltages are of opposite polarity. Whatever the operation mode, unipolar or bipolar, the amplitude of the switching voltage may be different for 'set' and 'reset'. In practice, the more reliable and usual operation is unipolar mode.

Nickel-oxide is used as a typical resistivity-switching material as it exhibits low switching currents (in the order of a fraction of a mA to a few mA, e.g. between 500 µA and 1 mA), switching voltages (smaller than 2 V, e.g. about 1 V) and forming voltages (e.g. in the range between 2 V and 3 V, e.g. 2 V). Hence it is particularly useful for low-power applications. Moreover, many deposition techniques are available, such as for example sputtering, ALD (Atomic Layer Deposition), pulsed laser deposition or MOCVD (Metal-Organic Chemical Vapour Deposition).

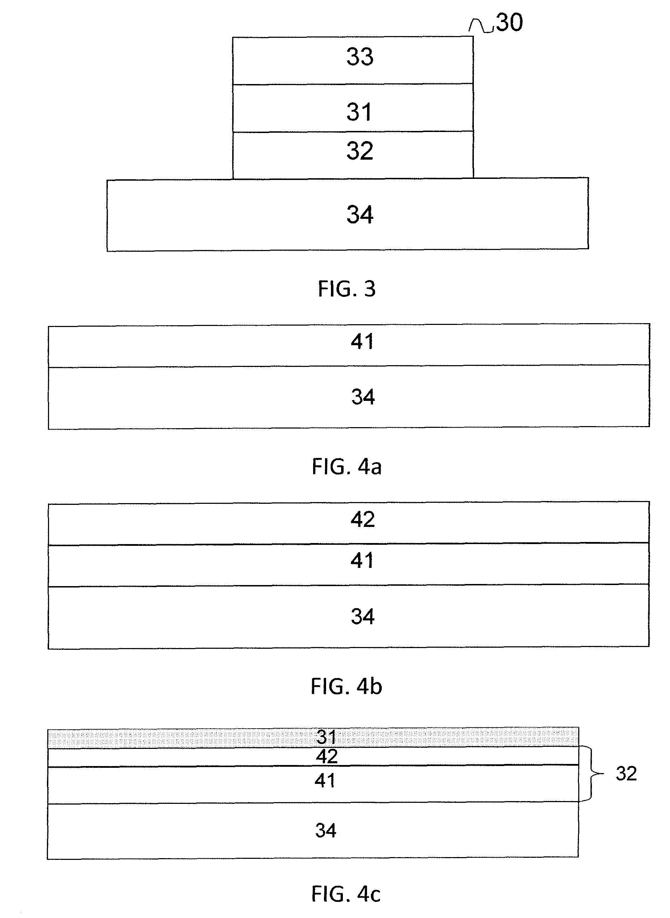

In one embodiment of the present invention, a method for forming a NiO resistive memory element is disclosed. FIG. 3 shows a cross-section of such memory element 30 comprising a resistive-switching nickel-oxide layer 31, sandwiched between a bottom electrode 32 and a top electrode 33. The bottom electrode 32 is formed on a substrate 34.

A manufacturing process according to an embodiment of the present invention may comprise the following steps, as illustrated in more detail by FIG. 4a to FIG. 4d:
- providing a substrate 34 with a bottom electrode 32, the bottom electrode 32 including a Ni layer 42,
- at least partially oxidizing the Ni layer 42, thus forming a resistive-switching NiO layer 31, and
- forming a top electrode 33 on the NiO layer 31.

As illustrated by FIG. 4a, a substrate 34 is provided. The substrate 34 can be made from any suitable material. The term "substrate" may include any underlying material or materials that may be used, or upon which a device may be formed. The substrate 34 can for example be a semiconductor material, such as e.g. a silicon-based substrate such as a bulk silicon wafer, a gallium arsenide (GaAs), a gallium arsenide phosphide (GaAsP), an indium phosphide (InP), a germanium (Ge), or a silicon germanium (SiGe) substrate. The "substrate" may include for example an insulating layer such as a SiO₂ or a Si₃N₄ layer in addition to a semiconductor substrate portion. Thus, the term substrate also includes silicon-on-insulator (SOI), silicon-on-glass, silicon-on sapphire substrates. The term "substrate" is thus used to define generally the elements for layers that underlie a layer or portions of interest, in particular a resistive switching device 30.

A bottom electrode 32 is formed on the substrate 34. In particular embodiments (not illustrated), the bottom electrode 32 may be electrically insulated from the substrate 34 by a suitable dielectric layer, such as for example a silicon oxide and/or silicon nitride layer, or by a junction in-between the substrate 34 and the bottom electrode 32.

The bottom electrode 32 may comprise a stack of layers. The top layer of the stack of layers may be a Ni layer. Other layers of the bottom electrode may promote the formation of Ni grains with an (111) orientation and/or suppress the formation of Ni grains with (100) orientation. The notation (100) indicates a set of equivalent directions. As Ni has a cubic symmetry, this notation includes e.g. (200) etc. Hence where an amount of Ni(200) is indicated in the drawings, this indicates an amount equivalent to the amount of Ni(100) as indicated in the description and claims. The values of Ni(200) and Ni(100) can be replaced by one another in view of the cubic symmetry of nickel crystals; Ni(100) and Ni(200) are equivalent planes.

In the example illustrated In FIG.4a, a first conductive layer 41 of the bottom electrode 32 is formed on a substrate 34. This layer may provide good adhesion of the bottom electrode to the underlying substrate 34 or dielectric layer. It may furthermore promote the subsequent growth of Ni grains with a (111) orientation and/or suppress the subsequent growth of Ni grains with a (100) orientation. Such first layer 41 of the bottom electrode 32 may for example be a TiN layer, a Pt layer, a W layer, a Ru layer, an Ir layer or an IrO₂ layer. In embodiments of the present invention, the first layer 41 of the bottom electrode 32 may in itself be formed by forming a multi-layer, e.g. by first forming a Ti layer over the substrate 34 and then forming a TiN layer over the Ti layer. The first layer 41 of the bottom electrode 32, e.g. the Ti and/or TiN layers 41, can be deposited in any suitable way, for example it or they can be deposited using an Ionised Metal Deposition (IMD) process, Physical Vapour Deposition (PVD) process or by a Chemical Vapour Deposition (CVD) process. The thickness of the Ti layer and the TiN layer can each range from 3 nm to 100 nm, for example a layer of Ti of between 15 and 40 nm, e.g. 20 nm and a layer of TiN of between 30 and 50nm e.g. 40 nm.

As illustrated in FIG. 4b a nickel metallic film 42 is formed on the exposed surface of the first layer 41 of bottom electrode 32, e.g. on the exposed surface of the TiN layer. The Ni layer 42 can be formed or deposited in any suitable way, for example using an Ionised Metal Deposition (IMD) process, a Physical Vapour Deposition (PVD) process, or by a Chemical Vapour Deposition (CVD) process. The thickness of the deposited nickel layer may be in the range of about 20 nm to about 250 nm, e.g. about 100 nm.

According to embodiments of the present invention, the formation of the Ni layer is such that formation of Ni grains with faster oxidizing grain orientations is suppressed and/or the formation of Ni grains with slower oxidizing grain orientations is promoted. This may in particular comprise suppressing formation of Ni grains with (100) orientations and/or promoting formation of metal grains, e.g. Ni grains, with (111) orientations. In embodiments of the present invention, the formation of the Ni layer is such that the relationship Ni(100)/Ni(111) < 0.1. This relationship can be determined from XRD measurements, which allow determining the texture/crystalline structure. If such XRD measurements are done a sufficient amount of time to receive a sufficient number of ticks an indication of relative amount of different crystal orientations present may be obtained.

The controllability of the NiO formation by suppressing formation of Ni grains, e.g. (100) oriented Ni grains, with faster oxidizing grain orientations and/or by promoting formation of Ni grains, e.g. (111) oriented Ni grains, with slower oxidizing grain orientations in the bottom electrode 32 provides good controllability of the resistive switching NiO-based ReRAM element to be formed.

Different methods to obtain such promotion of formation of Ni grains with (111) orientation and/or suppression of formation of Ni grains with (100) orientation may be implemented.

In a first embodiment, single crystal Ni(111) can be epitaxially grown. In this case, the underlying substrate 34 and/or the underlying first layer 41 of the bottom electrode can be selected so as to provide a good basis for epitaxially growing single crystal Ni(111).

In a second embodiment, the exposed surface of the first layer 41 is a N rich and Ti poor TiN layer. With "N rich and Ti poor" is meant that N and Ti are present in substoichiometric quantities in the TiN, i.e. Ti/N < 1.

After depositing the Ni layer 42 a thermal treatment (anneal, further called pre-anneal) may optionally be performed on the layer stack 41, 42. This thermal treatment step in an oxygen-free ambient is aimed at stabilizing the microstructure, such as grain size and crystal orientation of the as-deposited Ni layer 42, essentially without oxidizing the Ni layer 42. The layer stack 41, 42 may be heated during this thermal treatment step in a vacuum ambient. A thermal anneal step at about 500°C to 600°C for about 10 minutes under inert or non-oxidizing atmosphere can be used, e.g. under He or N₂, to prevent preliminary oxidation of the Ni layer 42. The temperature may be in the range from 400°C to 500°C for a time of 10 to 20 minutes. Temperature is not critical if not too low, but if the anneal time is too short, no or no good switching events may occur after complete formation of the ReRAM device. This anneal step is believed to stabilize and enhance the (111) crystal orientation of the as-deposited Ni layer 42. During this heating step the upper layer 42 of the bottom electrode 32 is believed to recrystallize: Ni grains grow and the Ni film gets denser.

As illustrated in FIG. 4c, the (optionally annealed) Ni layer 42 is at least partially, and optionally completely, converted into a nickel-oxide layer 31. The exposed upper part of the Ni layer 42 does contain oxygen, while a lower part of the Ni layer 42 remains unoxidised and is part of the bottom electrode 32.

If the Ni layer 42 is not completely converted into a nickel-oxide layer 31, the unoxidised bottom part of the Ni layer 42 provides a good adherence and low contact resistance for the oxidized upper art. This conversion of the Ni layer 42 into a stack of a nickel-oxide layer 31, and a Ni layer 42, can be done using various oxidation processes, such as e.g. thermal oxidation of the metal layer, plasma oxidation of the metal layer using e.g. microwave remote plasma oxidation, implantation of oxygen in the upper part of the Ni layer 42 followed by a thermal treatment step to form the nickel-oxide layer 31.

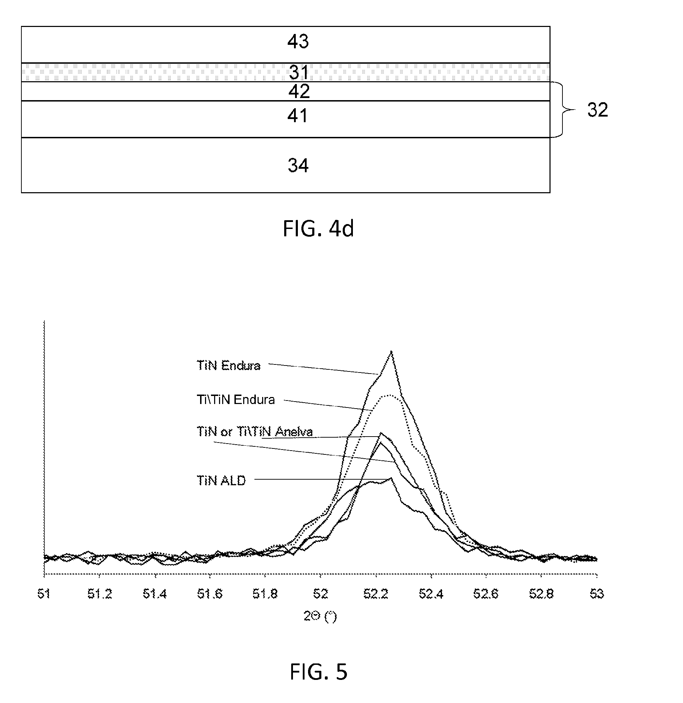

As illustrated in FIG. 4d the top electrode 43 is formed on the nickel-oxide layer 31 by forming one or more conductive layers in any suitable way, for example by an Ionised Metal Deposition (IMD) process, a Physical Vapour Deposition (PVD) process, or by a Chemical Vapour Deposition (CVD) process. The material of these top layers can be conductive materials such as for example, but not limited thereto, Ni, Ti, TiN, Pt. In particular embodiments, Ni is used to form the top electrode 43.

After forming the stack of bottom electrode layer(s) 32, nickel-oxide layer 31, and top electrode layer(s) 33, this stack is patterned resulting in an array of memory elements, like the memory element 30 illustrated in FIG. 3. Each memory element may be provided with a selection element, such as e.g. a diode or a transistor, for selecting an individual memory element 30, a memory element and a selection element forming a memory cell. As known by a person skilled in the art, additional processing may be performed to form an interconnect structure to the memory cells, allowing electrical access to an individual memory element for programming, writing and erasing thereof. Examples of interconnect structures and the manufacturing thereof are disclosed in WO 2007/062014, hereby incorporated by reference. Here a diode is integrated in the memory element as selection element, but as appreciated by a skilled person a transistor such as a MOSFET or a bipolar transistor can be present in the substrate 34 such that to each memory element 30 an individual transistor is connected as selection element.

### Experiment:

Ni films 42 deposited by sputtering were oxidized using ex-situ thermal anneal carried out at 400-550°C in oxygen atmospheres. The influence of the underlying layers was investigated by using different kinds of TiN films obtained via physical (sputtering/PVD) and chemical (ALD, MOCVD) deposition techniques.

FIG. 5 is an X-ray difractogram of Ni(200) (equivalent to Ni(100)) as-deposited on different types of TiN layers: TiN deposited by a PVD method using Applied Materials ENDURA^{®} PVD system, a stack of Ti/TiN deposited by an Endura method, TiN deposited by an PVD method using Canon-Anelva PVD system, a stack of Ti/TiN deposited by an Anelva method and TiN deposited by atomic layer deposition (ALD). It can be seen that an as-deposited Ni layer comprises different amounts of Ni(200), depending on the underlying TiN or Ti/TiN layers.

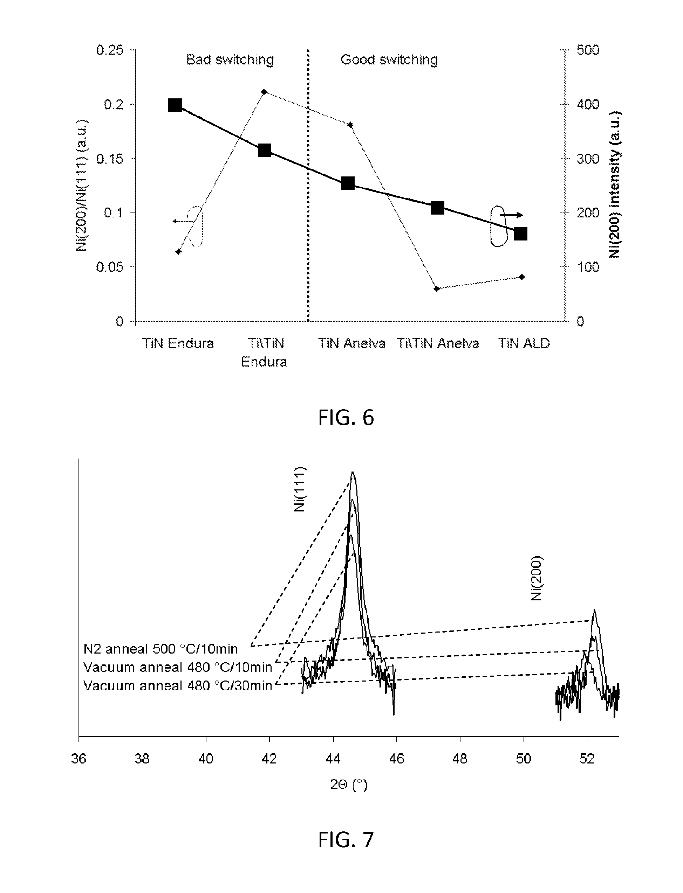

FIG. 6 sets out for each of the above graphs the Ni(200) intensity, as well as the relationship Ni(200)/Ni(111). It can be seen that lower Ni(200) intensities provide devices with good switching, while the relationship between Ni(200)/Ni(111) is not decisive on the switching properties (both high and low relationship results give both good and bad switching results).

While the NiO microstructure did not show major difference among these samples, these differences in switching correlated well with the presence of Ni(200) crystalline orientation in the initial Ni film, which may for example be enhanced by providing a N-rich (Ti/N < 1) TiN film underneath the initial Ni film.

The table below shows the composition, resistivity and crystal structure in as deposited TiN bottom electrodes of different types, also illustrated in FIG. 6.

| Deposition | Ti (at%) | N (at%) | O (at%) | others (at%) | pmW-cm | Crystallinity Fm-3m |
|---|---|---|---|---|---|---|
| PEALD | 40 | 50 | 6 | Cl: 2 | ∼200 | Cubic |
| 10nm | | | | | | (200)* |
| Anelva | 44 | 56 | | | 210-220 | Cubic |
| 50nm RT | | | | | | (200)* |
| Endura | 56.5 | 43.5 | | | ∼150 | Cubic |
| 50nm 300 °C | | | | | | (200)* |

| | | | | | | |
|---|---|---|---|---|---|---|
| * = main signal detected | | | | | | |

From FIG. 6 it is known that the Endura embodiments do not show good switching. Hence from the above table can be deduced that only N-rich TiN films provide good switching results.

A better understanding of this observation was achieved by the use of Ni single crystals. It has been observed that the oxidation rate clearly depends on the Ni crystalline orientation: NiO grows faster in Ni(100) as compared to Ni(111) single crystals. Electrical evaluations of the single crystals showed that the stability of the switching seems to be related to the thickness of the NiO film formed: a non-stable switching (with difficult reset) is obtained in Ni(100) single crystals, which simultaneously showed the highest initial resistance values indicative of a thick NiO; the initial resistance of NiO grown on Ni(111) single crystals was approximately six orders of magnitude lower as compared to the NiO obtained in Ni(100) single crystals: 3x10⁴ Ω vs. 1x10¹¹ Ω, respectively.

FIG. 7 illustrates X-ray diffractograms of Ni films (deposited on a Ti/TiN layer stack formed in PVD Anelva) after a pre-anneal (i.e. an anneal before a possible oxidizing anneal) under different circumstances (pre-anneal at 500°C during 10 minutes in a N₂ environment, pre-anneal at 480°C during 10 minutes in vacuum, and pre-anneal at 480°C during 30 minutes in vacuum). By the pre-anneal, formation of Ni(111) is enhanced, and this for different anneal methods as illustrated.

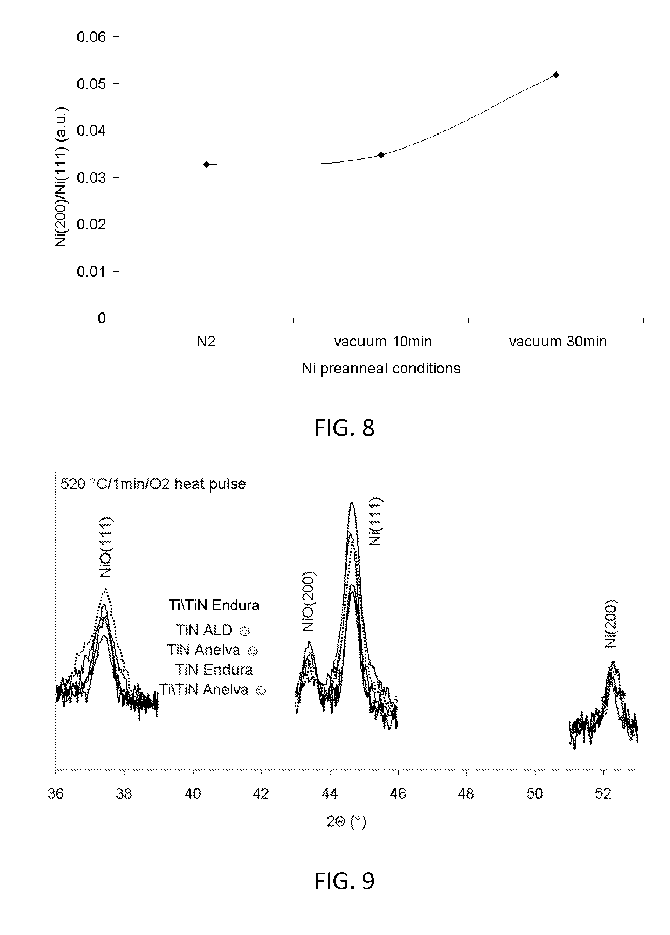

Different pre-anneal methods lead to different results with respect to Ni(200) to Ni(111) formation, and this relationship as illustrated in FIG. 7 is set out in FIG. 8. A Ni pre-anneal in N₂ environment at 500°C during 10 minutes as in FIG.7 leads to a lower Ni(200)/Ni(111) relationship than a Ni pre-anneal in vacuum at 480°C during 10 minutes, which again leads to a lower Ni(200)/Ni(111) relationship than a Ni pre-anneal in vacuum at 480°C during 30 minutes.

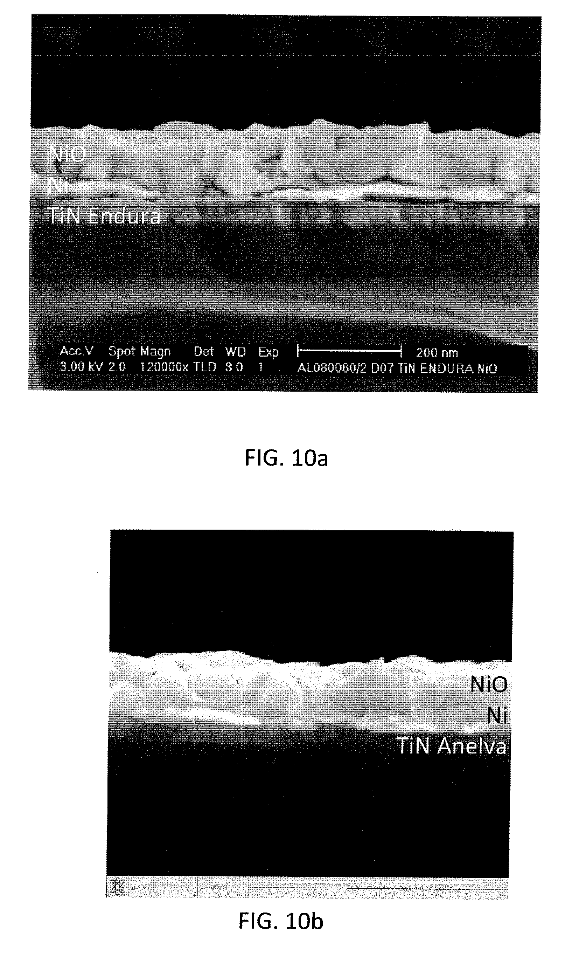

Different bottom electrode stacks have been investigated: TiN deposited by Endura Ti/TiN deposited by Endura, TiN deposited by Anelva, Ti/TiN deposited by Anelva and TiN deposited by ALD. As can be seen from FIG. 9, the NiO formed by oxidation of the bottom electrode stacks shows similar characteristics for all bottom electrode stacks investigated. The stack thickness (Ni+NiO) was in all cases about 150 to 160 nm. In all cases the NiO was polycrystalline, and their microstructure was similar, as can be seen from comparing FIG. 10a and FIG. 10b. However, experiments have shown that samples with no good switching consumed more Ni(200) in the formation of the NiO. This can be seen from comparison of FIG. 9, the graph after oxidation, with FIG. 5, before oxidation. In FIG. 5, the Endura deposited Ni films comprise more Ni(200) than Ni films deposited by other methods, while it can be seen from FIG. 9 that all embodiments comprise about the same Ni(200) component after oxidation. Hence, although starting from different Ni(200) signals in the as-deposited Ni layer, as the remaining Ni(200) concentration after oxidation is the same, embodiments with more Ni(200) in the as-deposited Ni layer consume more Ni(200) during the oxidation. Hence it is advantageous to promote the formation of Ni grains with slower oxidizing crystal orientations, Ni(111), and to suppress formation of Ni grains with faster oxidizing crystal orientations, Ni(200), as in accordance with the present invention.

While the invention has been illustrated and described in detail in the drawings and foregoing description, such illustration and description are to be considered illustrative or exemplary and not restrictive. The invention is not limited to the disclosed embodiments.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

The foregoing description details certain embodiments of the invention. It will be appreciated, however, that no matter how detailed the foregoing appears in text, the invention may be practiced in many ways. It should be noted that the use of particular terminology when describing certain features or aspects of the invention should not be taken to imply that the terminology is being re-defined herein to be restricted to include any specific characteristics of the features or aspects of the invention with which that terminology is associated.

## Claims

1. A method for forming a NiO resistive memory element, the memory element comprising a NiO resistive switching layer, the method comprising
obtaining a substrate,
providing a Ni layer on the substrate, and
at least partially oxidizing the Ni layer, thus forming the NiO resistive switching layer,
wherein obtaining a substrate comprises obtaining a substrate which promotes formation of Ni grains with slower oxidizing crystal orientations and/or suppresses formation of Ni grains with faster oxidizing crystal orientations.

2. A method according to claim 1, wherein obtaining a substrate comprises obtaining a substrate which promotes formation of Ni grains with (111) orientation.

3. A method according to any of the previous claims, wherein obtaining a substrate comprises obtaining a substrate which suppresses formation of Ni grains with (100) orientations.

4. A method according to any of the previous claims, wherein obtaining a substrate comprises obtaining a substrate provided with a N-rich, Ti-poor TiN layer.

5. A method according to any of claims 1 to 3, wherein providing a Ni layer comprises growing epitaxial (111) Ni.

6. A method according to any of the previous claims, wherein after providing the Ni layer but before oxidizing it, an anneal step is carried out on the Ni layer.

7. A method according to any of the previous claims, wherein providing a substrate includes providing a stable bottom electrode material.

8. A method according to any of the previous claims, furthermore comprising forming a top electrode on the NiO resistive switching layer.

9. A resistivity-switching non-volatile memory element obtained by a method according to any of claims 1 to 8.

10. A resistivity-switching non-volatile memory element comprising a bottom electrode and a NiO resistive switching layer, wherein the bottom electrode comprises a N-rich, Ti-poor TiN layer.

11. A memory cell comprising a resistivity-switching non-volatile memory element according to any of claims 9 or 10, and a selection element.

12. A method for promoting formation of Ni grains with (111) orientation, the method comprising providing a N-rich, Ti-poor TiN bottom electrode layer under the Ni layer.
